Europäisches Patentamt

European Patent Office

Office européen des brevets

(11) Numéro de publication: **0 330 942 B1**

## (12) FASCICULE DE BREVET EUROPEEN

(45) Date de publication de fascicule du brevet: **07.07.93**  (51) Int. Cl.⁵: **G01D 13/10**, G01R 1/08

(21) Numéro de dépôt: **89102846.6**

(22) Date de dépôt: **18.02.89**

(54) **Dispositif d'affichage pour instrument de mesure.**

(30) Priorité: **29.02.88 FR 8802591**

(43) Date de publication de la demande:
**06.09.89 Bulletin 89/36**

(45) Mention de la délivrance du brevet:
**07.07.93 Bulletin 93/27**

(84) Etats contractants désignés:
**BE CH DE ES FR GB IT LI NL SE**

(56) Documents cités:
**DE-A- 2 946 328**
**GB-A- 2 056 067**
**US-A- 4 174 500**

(73) Titulaire: **ASULAB S.A.**
**Faubourg du Lac 6**
**CH-2501 Bienne(CH)**

(72) Inventeur: **Grupp, Joachim**
**Chemin Gabriel 26**
**CH-2034 Peseux(CH)**
Inventeur: **Ruedin, Yves**
**Chemin des Deleynes 23**
**Ch-2072 St-Blaise(CH)**
Inventeur: **Wiget, Fridolin**
**Avenue des Alpes 22**
**CH-2000 Neuchâtel(CH)**
Inventeur: **Häring, Jean-Pierre**
**Grand-Chézard 5**
**CH-2054 Chézard(CH)**

(74) Mandataire: **Barbeaux, Bernard et al**
**ICB Ingénieurs Conseils en Brevets SA Passage Max. Meuron 6**
**CH-2001 Neuchâtel (CH)**

EP 0 330 942 B1

## Description

La présente invention concerne les dispositifs d'affichage pour instruments de mesure.

Il existe actuellement deux types de dispositifs d'affichage pour les instruments de mesure qui sont les dispositifs d'affichage analogique et les dispositifs d'affichage numérique.

D'une façon générale les dispositifs d'affichage analogique sont moins précis que les dispositifs d'affichage numérique mais ils présentent par rapport à ceux-ci un avantage.

Ils permettent d'apprécier rapidement la valeur de la grandeur qu'ils affichent et si cette valeur n'est pas constante de se rendre compte facilement de la façon dont elle varie.

Or ceci est important pour certaines applications.

C'est le cas par exemple pour des dispositifs d'affichage qui sont destinés à faire partie d'un poste de surveillance d'une installation, comme une centrale électrique, qui en réunit un grand nombre. Les dispositifs d'affichage analogique permettent alors d'avoir une bonne vue d'ensemble et de constater très vite que l'installation fonctionne correctement ou qu'il a une anomalie quelque part.

C'est également le cas pour un tableau de bord de véhicule automobile où les dispositifs d'affichage sont moins nombreux mais où ceux-ci doivent permettre au conducteur de savoir à peu près à quelle vitesse il roule, quel est le nombre de tours par minute de son moteur, combien il lui reste d'essence, etc., simplement en jetant un rapide coup d'oeil sur ce tableau.

D'autre part, il existe actuellement des instruments de mesure dans lesquels l'organe indicateur du dispositif d'affichage est directement entraîné par un capteur sensible à la grandeur à mesurer mais la plupart du temps le déplacement de l'organe indicateur est en relation indirecte avec cette grandeur. Ainsi, très souvent la grandeur est d'abord traduite en un courant électrique dont la valeur est fonction de celle de la grandeur et qui est appliqué à galvanomètre chargé d'entraîner l'organe indicateur.

Or, cette façon de faire présente plusieurs inconvénients.

Premièrement, on ajoute à l'erreur de mesure une erreur propre au galvanomètre qui peut varier en fonction de la valeur de la grandeur mesurée.

Deuxièmement, les galvanomètres sont souvent sensibles aux chocs et aux vibrations.

Troisièmement, les instruments de mesure et de contrôle font très souvent appel maintenant à la technique digitale dans laquelle la valeur de la grandeur est représentée par une information composée d'une suite d'états logiques qui peut être affichée directement par un dispositif d'affichage numérique. Ceci est d'autant plus vrai que l'on dispose actuellement de capteurs qui fournissent directement un signal digital représentatif de la valeur du paramètre qu'ils détectent. C'est le cas par exemple pour les capteurs de température ou de pression à quartz. Donc, si pour les raisons que l'on a indiquées précédemment, on veut utiliser pour des instruments de ce genre des dispositifs d'affichage analogique on est obligé de faire appel aussi à des convertisseurs digitaux/analogiques qui sont relativement coûteux.

Enfin, quatrièmement, avec un galvanomètre on ne peut pas faire faire à l'aiguille qu'il entraîne autant de tours que l'on veut. Or, pour certains instruments comme les altimètres, il serait avantageux d'avoir une aiguille qui ferait plusieurs fois le tour d'un cadran dans le même sens tant que la valeur de la grandeur augmenterait et qui indiquerait avec précision par exemple les unités et éventuellement les dixièmes et un dispositif d'affichage digital tel qu'un dispositif à tambours qui serait couplé au système d'entraînement de l'aiguille et qui indiquerait, lui, les dizaines, les centaines, etc.

On connait actuellement, grâce notamment au brevet US no 4 314 146, une solution qui permet d'éliminer tous ces inconvénients. Cette solution consiste à employer, pour entraîner l'organe indicateur, un moteur pas à pas bidirectionnel.

Malheureusement, le seul fait d'utiliser un moteur pas à pas ne permet pas d'éliminer aussi un autre inconvénient de certains dispositifs d'affichage analogique, qui est le suivant :

Lorsqu'on réalise un appareil à affichage numérique qui permet de mesurer plusieurs grandeurs et certaines de ces grandeurs dans des domaines de valeurs différents, comme par exemple un multimètre, on n'utilise généralement qu'un seul dispositif d'affichage électrooptique pour indiquer les résultats de toutes les mesures.

Par contre, dans le cas d'un multimètre à affichage analogique classique, on est obligé de prévoir plusieurs échelles graduées sur le cadran, ce qui rend la lecture de la valeur d'une grandeur plus difficile. Ceci est d'autant plus vrai qu'en général, pour éviter que l'appareil devienne trop encombrant à cause du cadran, on s'arrange lorsque c'est possible, pour que certaines échelles servent chacune à lire des valeurs d'au moins deux grandeurs et dans des plages différentes. C'est ainsi que dans un multimètre classique une seule échelle graduée de 0 à 100 sert à lire à la fois des valeurs de tensions comprises entre 0 et 1 mV, 10 mV, 100 mV, 1 V, 10 V, 100 V et 1 KV et des valeurs d'intensité de courant comprises entre 0 et 1 $\mu$A, 10 $\mu$A, 100$\mu$A, 1 mA, 10 mA, 100 mA et 1 A. Donc si l'on place le bouton de sélection dans la position pour laquelle l'échelle corespond à la plage 0-10 mA il faut se rappeler que lorsqu'on lit par exemple 45 sur le cadran l'intensité que l'on mesure n'est pas égale à 45 mA mais à 4,5 mA.

Le brevet US 4 174 500 décrit un dispositif d'affichage pour multimètre qui permet de résoudre tout au moins en grande partie ce problème de difficulté de lecture.

Ce dispositif comprend une plaque de support sur laquelle sont montées des cellules d'affichage à cristal liquide qui sont conçues pour afficher chacune une échelle avec le symbole de l'unité de base de la grandeur à laquelle elle correspond et un système d'alimentation et de commutation qui permet de ne faire fonctionner que la cellule qui correspond à la grandeur qui est ou va être mesurée. Grâce à cela la lecture d'une valeur indiquée par l'aiguille du dispositif devient aussi facile qu'avec un appareil de mesure simple, par exemple un voltmètre, dont le cadran ne porte qu'une seule échelle.

De plus, comme l'indique également ce brevet, il est possible de réaliser chaque cellule de façon qu'elle puisse en plus afficher sélectivement, devant le symbole de l'unité de base de la grandeur à laquelle elle correspond d'autres lettres qui sont utilisées habituellement pour représenter des multiples et des sous-multiples de cette unité, par exemple un K ou un M devant le Ω d'une échelle de valeurs de résistance et un m ou un k devant le V d'une échelle de valeurs de tension.

Pour certains multimètres relativement simples cela suffirait pour permettre de lire directement sur le cadran la valeur de la grandeur mesurée.

Par contre, pour un multimètre comme celui dont on a parlé précédemment il faudrait quand même continuer le plus souvent à se rappeler par combien la valeur que l'on lit sur l'échelle que l'on voit doit être multipliée ou divisée. Donc, dans ce cas le problème de difficulté de lecture ne serait pas totalement résolu.

Cela dit et pour en revenir aux tableaux de bord de véhicules automobiles dont il a déjà été question, on peut considérer que parmi les informations qu'ils peuvent afficher actuellement de façon analogique il y a, d'une part, la vitesse qui doit toujours être indiquée et, d'autre part, des paramètres comme les tours par minute, le niveau d'essence, les températures d'eau et d'huile, la pression et le niveau d'huile, la tension de batterie, etc., qui n'ont pas absolument besoin d'être affichés en permanence et qui ne pourraient apparaître qu'à la demande du conducteur, par exemple lorsqu'il appuierait sur une touche, et lorsque leur valeur s'approcherait d'un seuil critique.

De cette façon le conducteur pourrait avoir à sa disposition à un moment donné ou continuellement, toutes les informations qu'il désirerait et uniquement celles-là. De plus, il serait sûr d'être averti s'il y avait un défaillance dans le fonctionnement de son véhicule ou si celui-ci allait bientôt manquer de quelque chose (essence, eau, huile, etc.).

Par ailleurs, il serait intéressant aussi parfois de pouvoir modifier l'échelle sur laquelle une grandeur est indiquée.

Enfin, on commence maintenant à équiper les véhicules de systèmes électroniques de contrôle qui comportent un très grand nombre de capteurs et un microprocesseur qui centralise les informations fournies par ces capteurs pour commander automatiquement le fonctionnement de certaines parties du véhicule et faire afficher certaines de ces informations par les instruments du tableau de bord.

Grâce à cela les informations qui pourraient être portées utilement à la connaissance du conducteur sont beaucoup plus nombreuses que celles qui l'étaient en général jusqu'à présent.

Or, si pour les raisons que l'on a indiquées au début on voulait faire afficher toutes les informations qui le peuvent par des dispositifs d'affichage analogique classiques on serait pratiquement obligé de rassembler la plupart de ces informations par groupes et de faire afficher chaque groupe par un même dispositif. Mais, d'une part, il n'est pas certain que le tableau de bord pourrait alors continuer à occuper une surface raisonnable et, d'autre part, on retomberait alors sur le problème de difficulté de lecture dont on a parlé à propos des multimètres et qui serait dans ce cas beaucoup plus gênant.

Naturellement, ce problème de lecture pourrait être résolu en utilisant des dispositifs d'affichage comme celui qui fait l'objet du brevet US 4 174 500 dont on a déjà parlé, mais ceux-ci tiendraient au moins autant de place que des dispositifs à cadran ordinaire.

D'autre part, l'emploi de tels dispositifs présenterait en plus deux inconvénients beaucoup plus importants ici que dans le cas d'un multimètre. Le premier inconvénient c'est que le tableau de bord devrait comporter un nombre relativement grand de cellules et que par conséquent il reviendrait cher. Le second inconvénient c'est que ce tableau de bord risquerait alors de ne pas être très esthétique.

La présente invention a pour but de fournir une solution plus économique et surtout plus efficace que celle du brevet US 4 174 500 aux différents problèmes qui viennent d'être exposés et qui ne se posent évidemment pas que pour des multimètres et des tableaux de bord.

Un autre but de l'invention est de fournir un dispositif d'affichage qui offre toutes les possibilités qui ont été envisagées précédemment lorsqu'il fait effectivement partie d'un tableau de bord de véhicule.

Ces buts sont atteints grâce au fait que le dispositif d'affichage de la valeur d'au moins une grandeur selon l'invention, qui comprend alors lui aussi un organe indicateur mobile entraîné par un moteur pas à pas, un premier circuit de commande qui répond au moins indirectement à une information d'entrée qui représente la grandeur en question en appliquant au moteur des impulsions motrices pour amener l'organe indicateur dans une position qui correspond à la valeur de la grandeur, et des moyens pour présenter au moins deux systèmes de repérage qui coopèrent avec l'organe indicateur pour indiquer au moins dans quel domaine se situe cette valeur, ces moyens comprennent une seule cellule d'affichage électro-optique conçue pour afficher les deux systèmes de repérage sélectivement et sensiblement au même endroit, en réponse à des signaux de commande, et grâce au fait que ce dispositif comprend également un deuxième circuit de commande pour appliquer ces signaux de commande à la cellule en réponse à un signal d'activation et que le deuxième circuit de commande reçoit également un signal de sélection pour pouvoir appliquer à la cellule des signaux de commande différents afin de l'amener à afficher l'un ou l'autre des systèmes de repérage.

L'expression "cellule d'affichage électro-optique" désigne ici une cellule qui comporte au moins deux plaques isolantes entre lesquelles est emprisonnée une couche de matériau capable de répondre à la présence d'un champ électrique par une modification de son comportement optique et des électrodes portées par ces plaques, qui permettent de créer le champ en question.

Il peut donc s'agir par exemple d'une cellule à cristal liquide capable d'afficher les systèmes de repérage en sombre sur fond clair ou, au contraire, en clair sur fond sombre. Comme on le verra par la suite chacune de ces façons d'afficher les systèmes de repérage présente des avantages et on peut être amené à choisir l'une plutôt que l'autre, en fonction de l'application à laquelle le dispositif d'affichage est destiné.

D'autre part, les deux systèmes de repérage qui sont, par exemple, deux échelles graduées peuvent correspondre à des domaines de valeurs différents de la même grandeur et le dispositif peut comporter en plus des moyens qui reçoivent également le signal de sélection et qui traitent l'information d'entrée avant de l'envoyer au premier circuit de commande, afin que le nombre d'impulsions motrices appliquées au moteur soit adapté au système de repérage affiché par la cellule.

Une autre possibilité, c'est que les deux systèmes de repérage soient prévus pour indiquer les valeurs de grandeurs différentes, que ces valeurs soient représentées par des informations d'entrée respectives reçues par le dispositif d'affichage et que celui-ci comprenne également des moyens qui reçoivent le signal de sélection et qui sélectionnent l'information d'entrée qui correspond au système de repérage affiché par la cellule pour l'appliquer au premier circuit de commande.

D'autres caractéristiques et avantages de l'invention apparaitront à la lecture de la description qui suit et qui se réfère au dessin annexé sur lequel :

- la figure 1 représente schématiquement un voltmètre muni d'un dispositif d'affichage conforme à l'invention, qui permet d'indiquer des valeurs de tension sur deux échelles différentes ;
- les figures 2a et 2b sont des vues schématiques en coupe de deux cellules d'affichage à cristal liquide qui peuvent être utilisées dans le voltmètre de la figure 1 ;
- la figure 3 montre une configuration possible pour les électrodes des cellules des figures 2a et 2b, qui permet d'afficher sélectivement les deux échelles en question au même endroit ;
- les figures 3a, 3b et 3c montrent, à plus grande échelle, la configuration de trois digits qui doivent permettre d'afficher des chiffres différents sur les deux échelles ;
- les figures 4a et 4b montrent ces deux échelles ; et
- la figure 5 montre comment le circuit de commande de la cellule peut être réalisé lorsque ses électrodes ont la configuration représentée sur la figure 3 ;

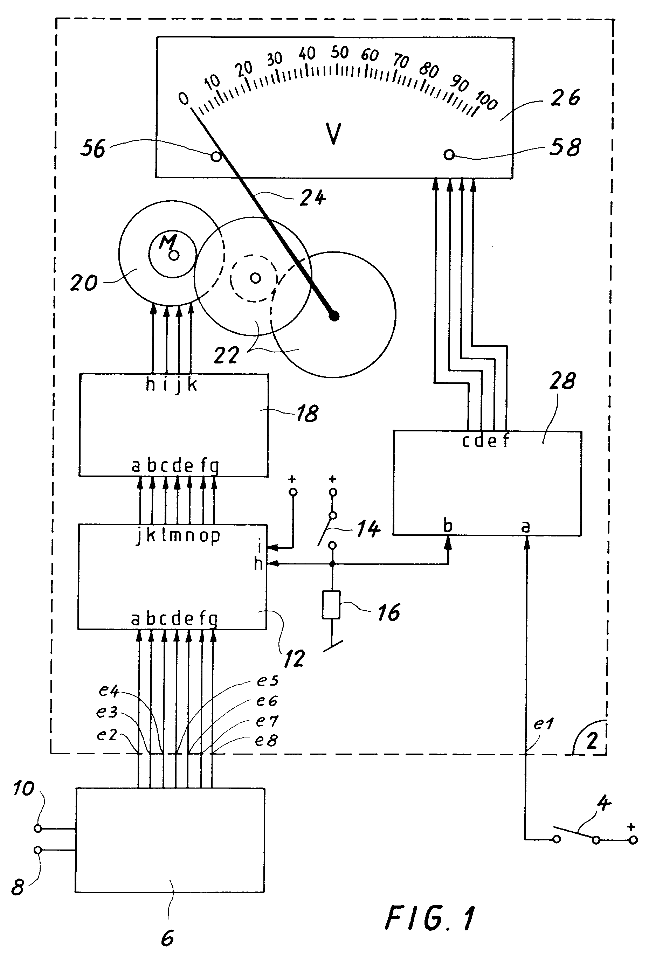

Le voltmètre qui est représenté schématiquement sur la figure 1 est destiné à mesurer des tensions comprises entre 0 et 100 V.

Son dispositif d'affichage 2 est conçu pour permettre de lire la valeur d'une tension sur des échelles graduées de 0 à 100 V et de 0 à 30 V.

Ce dispositif possède une première entrée e1 reliée à un interrupteur de branchement 4 qui permet de mettre l'ensemble des circuits du voltmètre sous tension en les reliant à la borne positive d'une source de tension continue d'alimentation non représentée.

Comme on le verra par la suite le signal produit par la fermeture de cet interrupteur 4 constitue ici le signal d'activation dont on a parlé.

Le dispositif 2 possède également sept autres entrées e2 à e8 par lesquelles il peut recevoir une information de sept bits qui est fournie par un circuit de mesure 6 lorsque le voltmètre est branché et qu'une tension est appliquée entre les bornes d'entrée 8 et 10 de celui-ci, cette information étant bien entendu représentative de la valeur de ladite tension.

Les sept entrées e2 à e8 sont reliées à sept entrées correspondantes a à g d'un circuit multiplicateur à deux bits 12 qui comporte également deux autres entrées h et i pour déterminer son taux de multiplication et sept sorties j à p.

L'entrée h est reliée à la borne commune d'un interrupteur 14, dont l'autre borne est connectée à la borne positive de la source de tension d'alimentation du voltmètre, et d'une résistance 16 dont l'autre borne est reliée à la masse.

Par contre, l'entrée i est connectée directement à la borne positive de la source.

Ainsi, lorsque l'interrupteur 14 est ouvert les entrées h et i sont respectivement aux états logiques "0" et "1", ce qui correspond au nombre binaire 01. Donc, dans ce cas, le circuit multiplicateur se contente de transmettre l'information qu'il reçoit sur ses entrées a à g à ses sorties j à p.

Si, au contraire, l'interrupteur 14 est fermé les entrées h et i sont toutes les deux à l'état "1", ce qui correspond au nombre binaire 11, et l'information d'entrée est alors multipliée par 3.

A noter que ce qui commande en fait la multiplication par 1 ou par 3 du signal d'entrée du circuit, c'est le signal logique de sélection produit par l'interrupteur 14, puisque l'état logique de l'entrée i ne change pas.

Les sept sorties du circuit multiplicateur 12 sont reliées à leur tour à sept entrées correspondantes a à g du circuit de commande 18 d'un moteur pas à pas bidirectionnel 20 qui est couplé à une aiguille 24, par l'intermédiaire d'un rouage 22, de façon à pouvoir la faire pivoter autour d'un axe, dans les deux sens et dans des limites qui seront précisées par la suite.

Enfin, le dispositif d'affichage 2 comporte un cadran 26 qui est constitué ici entièrement par une cellule d'affichage à cristal liquide, qui permet de faire apparaître sélectivement, au même endroit, les deux échelles graduées de 0 à 100 V et de 0 à 30 V, et un circuit de commande 28 pour cette cellule, qui a deux entrées a et b reliées respectivement à l'entrée e1 du dispositif et à la borne commune de l'interrupteur 14 et de la résistance 16 et quatre sorties c à f.

Le moteur 20 peut être par exemple celui qui fait l'objet du brevet US 4 361 790. Ce moteur comprend un rotor constitué par un aimant bipolaire à aimantation diamètrale, un stator avec trois parties polaires qui entourent le rotor et deux bobines qui doivent être alimentés par des impulsions motrices bipolaires pour faire tourner le rotor dans un sens ou dans l'autre, par pas de 180°. Généralement les deux bobines d'un tel moteur sont alimentées simultanément, ce qui fait qu'elles doivent être branchées chacune en diagonale dans un pont de quatre transistors de puissance. Cela explique les quatre conducteurs qui relient le moteur 20 à quatre sorties j à k du circuit de commande 18 sur la figure 1.

Le circuit de commande 18 ne sera pas décrit ici car il peut former, avec le circuit multiplicateur 12, l'interrupteur 14 et la résistance 16, le même circuit que celui qui est décrit dans le brevet US no 4 314 146 précité.

La seule chose qui n'est pas précisée dans ce brevet c'est la façon dont est réalisé le circuit qui permet de générer les impulsions motrices du moteur en réponse à des impulsions périodiques produites par un générateur d'impulsions commandable et à un signal de commande de sens de rotation du moteur. Or il existe déjà de tels circuits pour des moteurs comme celui du brevet US no 4 361 790, notamment dans des montres.

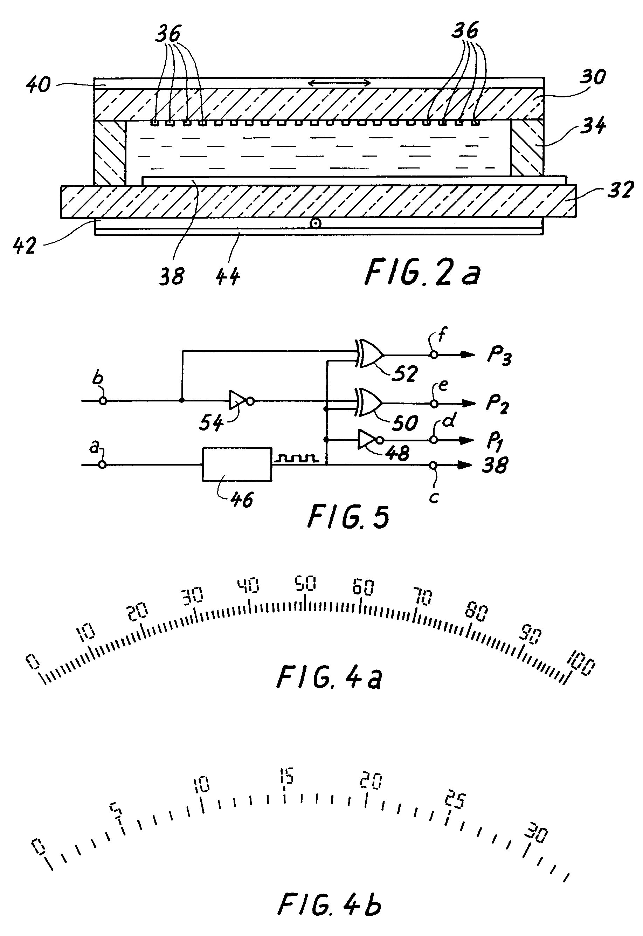

En ce qui concerne la cellule 26, elle peut être théoriquement de n'importe quel type connu actuellement. Toutefois, pour un voltmètre comme celui que l'on est en train de décrire, il est préférable d'utiliser une cellule fonctionnant par réflexion, comme par exemple l'une de celles qui sont représentées schématiquement, en coupe, sur les figures 2a et 2b.

Pour d'autres applications, comme par exemple un tableau de bord de véhicule, on pourrait être amené dans certains cas à choisir plutôt une cellule qui fonctionne à la fois par réflexion pour la lecture de jour et par transmission pour la lecture de nuit.

La cellule qui est représentée sur la figure 2a est une cellule à contraste positif, c'est-à-dire une cellule qui permet d'afficher des échelles en sombre sur fond clair et à laquelle doit être associée évidemment une aiguille 24 noire ou de couleur sombre.

Cette cellule de la figure 2a comprend une plaque avant 30 et une plaque arrière 32 transparentes et réunies entre elles par un cadre 34, de façon à former une enceinte étanche dans laquelle est emprisonné une couche de cristal liquide nématique à anisotropie diélectrique positive.

La plaque avant 30 porte sur sa face interne un ensemble d'électrodes transparentes 36, par exemple en oxyde d'indium ou d'étain, dont la configuration correspond à celle des échelles, et une couche d'alignement non représentée pour orienter les molécules du cristal liquide ou du mélange qui se trouvent dans son voisinage dans une direction parallèle aux plaques et au plan de la figure, ceci en l'absence de champ électrique.

Par ailleurs, sur la face interne de la plaque arrière 32 se trouvent une contre-électrode transparente 38, qui recouvre cette plaque au moins dans toute la zone d'affichage, et une couche d'alignement également non représentée pour orienter les molécules du cristal liquide qui sont proches d'elle toujours dans une direction parallèle aux plaques mais perpendiculairement au plan de la figure.

Enfin, la cellule de la figure 2a comprend également un premier polariseur 40, qui est fixé sur la face externe de la plaque avant 30 et dont la direction de polarisation est parallèle aux plaques et au plan de la figure, un second polariseur 42, fixé sur la face externe de la plaque 32, dont la direction de polarisation est perpendiculaire à celle du premier polariseur, et un réflecteur-diffuseur 44 fixé sur la face arrière de ce second polariseur.

Le fonctionnement d'une telle cellule que l'on appelle généralement cellule nématique tordue ou nématique en hélice (en anglais "twist nematic") est bien connu. Il n'est donc pas nécessaire de le décrire ici.

On sait aussi que pour transformer une cellule de ce type en une cellule à contraste négatif, capable de faire apparaître des échelles en clair sur fond sombre, il suffit de remplacer l'un des polariseurs 40 et 42 par un polariseur dont la direction de polarisation est parallèle à celle de l'autre.

La cellule de la figure 2b est un autre genre de cellule qui permet également d'afficher des échelles en clair sur fond sombre.

Elle comprend une plaque avant 30', une plaque arrière 32', un cadre 34', un ensemble d'électrodes 36' et une contre-électrode 38' qui sont identiques à ceux de la cellule de la figure 2a et disposés de la même façon. De plus, elle comporte elle aussi un réflecteur-diffuseur 44' placé à l'arrière de la plaque 32'.

En fait, ce qui la distingue de celle de la figure 2a c'est :

1. qu'elle ne comporte plus qu'un seul polariseur 42' qui est placé sur le dessin entre la plaque arrière 32' et le réflecteur-diffuseur 44' mais qui pourrait aussi se trouver sur la plaque avant 30' ;

2. que l'enceinte formée par les plaques 30' et 32' et le cadre 34' ne contient plus seulement un cristal liquide à anisotropie diélectrique positive mais un mélange d'un tel cristal avec un colorant pléochroïque qui présente un coefficient d'absorption élevé pour la plupart des longeurs d'ondes visibles et qui peut être par exemple celui qui est décrit dans la demande de brevet allemand No 3028593 ; et

3. que les couches d'alignement planaire non représentées dont les faces internes des plaques 30' et 32' sont elles aussi revêtues sont prévues pour qu'en absence de champ électrique les molécules du cristal liquide et du colorant pléochroïque soient toutes orientées dans une même direction qui est à la fois parallèle aux plaques et à la direction de polarisation du polariseur 42'.

Cette cellule que l'on désigne généralement sous le nom de son inventeur HEILMEIER est également bien connue et sans avoir besoin de donner des explications sur son fonctionnement on peut dire que grâce à la présence du colorant pléochroïque elle permet d'afficher des échelles sur un fond pratiquement noir, ce qui fait que si l'on choisit, comme il se doit, une aiguille blanche ou de couleur claire et de préférence brillante elle se détache très bien de ce fond. Naturellement, si on le souhaitait, on pourrait aussi utiliser, à la place de celui que l'on a indiqué, un colorant pléochroïque qui n'absorberait qu'une partie des longueurs d'ondes visibles pour obtenir un fond non pas noir mais de couleur sombre.

D'autre part, on peut citer sans les décrire deux autres exemples de cellules connues qui fonctionnement par réflexion et qui pourraient remplacer celles des figures 2a et 2b.

Le premier exemple c'est une cellule qui est décrite dans le brevet US No 3 833 287 et qui utilise un mélange de cristal liquide nématique à anisotropie diélectrique positive, de colorant pléochroïque et de cristal liquide cholestérique ou d'agent chiralique ainsi que des couches d'alignement planaire. Cette cellule est à contraste négatif et ne nécessite aucun polariseur.

Le deuxième exemple c'est une cellule comme celle qui est décrite dans le brevet US No 4 281 903 et qui comprend un mélange de cristal liquide nématique à anisotropie diélectrique négative, d'agent chiralique et de colorant pléochroïque et des couches d'alignement homéotropes sur ses plaques qui permettent d'orienter les molécules du mélange perpendiculairement à ces dernières, en l'absence de champ électrique. Cette cellule qui fonctionne elle aussi sans polariseur est à contraste positif.

D'une façon générale une cellule qui affiche quelque chose en sombre sur fond clair présente un meilleur contraste et une plus grande luminance qu'une cellule qui affiche la même chose en clair sur fond sombre.

Par contre, si l'on réalise deux systèmes d'affichage semblables un avec une aiguille sombre placée devant un cadran constitué par une cellule qui peut afficher une échelle avec un contraste positif et l'autre avec une aiguille claire placée à la même distance devant un cadran formé par une cellule qui peut afficher la même échelle avec un contraste négatif et si l'on compare les deux on s'aperçoit que le second système est nettement plus esthétique que le premier et que cela provient en grande partie du fait que l'aiguille paraît être plus proche du cadran.

En effet, la surface d'une cellule qui constitue le fond sur lequel l'échelle peut apparaître est la surface la plus éloignée de l'aiguille qui réfléchit de la lumière susceptible d'atteindre l'oeil d'une personne qui la regarde.

Dans une cellule de type "twist nematic" comme celle de la figure 2a ou d'une cellule du genre de celle qui est décrite dans le brevet US No 3 833 287 cette surface se situe au niveau de la face avant du réflecteur-diffuseur qui est à l'arrière de cette cellule.

Par contre, dans une cellule "twist nematic" à contraste négatif comme celle à laquelle on a fait allusion elle se trouve au niveau du polariseur qui est placé sur sa plaque avant et dans une cellule de HEILMEIER ou une cellule comme celle qui est décrite dans le brevet US No 4 281 903 pratiquement au niveau de la face interne de leur plaque avant, donc dans tous les cas nettement plus près de l'aiguille.

De plus avec ces cellules qui affichent en clair sur fond sombre l'ombre de l'aiguille sur le cadran peut être très estompée et même totalement supprimée lorsque le fond est vraiment noir.

Par conséquent, pour un voltmètre comme celui de la figure 1, on peut choisir une cellule à contraste positif ou une cellule à contraste négatif en fonction de l'importance que l'on attache aux avantages que chacune d'elles présente, avec peut-être quand même une préférence pour la première qui permet de lire plus facilement les valeurs des tensions que l'on mesure.

Pour un dispositif d'affichage de tableau de bord de véhicule qui, lui, à intérêt à être esthétique et qui ne doit pas être très lumineux pour ne pas gêner le conducteur, notamment la nuit, on opterait plutôt pour une cellule à contraste négatif.

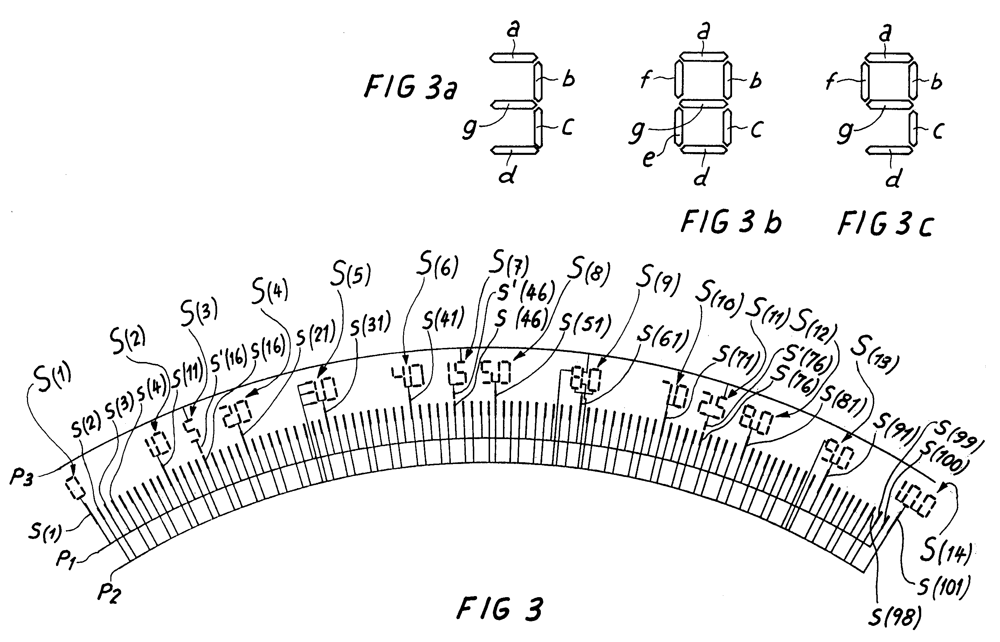

La figure 3 montre comment l'ensemble des électrodes 36 de la cellule de la figure 2a ou des électrodes 36′ de la cellule de la figure 2b peut être réalisé pour permettre d'afficher sélectivement une échelle graduée de 0 à 100 ou une échelle graduée de 0 à 30.

Cet ensemble comprend 101 segments radiaux et équidistants s(1) à s(101) pour faire apparaitre les graduations des deux échelles, quatorze groupes de segments S(1) à S(14) pour afficher au-dessus des graduations correspondantes les nombres de repèrage 0, 10, 20, 30, 40, 50, 60, 70, 80, 90 et 100 pour l'échelle de 0 à 100 et les nombres 0, 5, 10, 20, 25 et 30 pour l'échelle de 0 à 30 qui, comme on le verra par la suite, va en réalité un peu plus loin, et trois segments s′(16), s′(46) et s′(76) qui permettent de prolonger les segments s(16), s(46) et s(76) pour l'échelle de 0 à 30.

On voit en effet que, comme pour une échelle d'un cadran classique, les segments s(1), s(11), s(21),..., s(91) et s(101) qui correspondent aux graduations 0, 10, 20,..., 100 sont plus longs que les autres. Or les graduations que les segments s(1), s(31), s(61) et s(91) permettent d'afficher sont communes aux deux échelles. Il est donc souhaitable, pour une question d'uniformité et de facilité de lecture, que les graduations qui correspondent à 5, 15 et 25 V sur l'échelle de 0 à 30 aient la même longueur que celles qui correspondent à 0, 10, 20, et 30 V.

On peut voir également sur la figure 3 que l'ensemble des segments pour les graduations et les nombres de repèrage sont reliés à seulement trois pistes conductrices P1, P2 et P3.

En effet, tous les segments radiaux s(1), s(4), s(7), ..., s(97), s(100), autrement dit tous les segments s(3n + 1) (avec n ≥ 0), qui permettent de faire apparaître les graduations communes aux deux échelles, sont reliés à la piste P1.

Tous les segments s(3n + 2) et s(3n + 3) qui ne doivent faire apparaître que des graduations de l'échelle 0-100 sont reliés à la piste P2.

Les six segments du groupe S(1) qui forment le chiffre 0 sont reliés entre eux et à la piste P1.

Les huit segments du groupe S(2) qui forment le nombre 10 sont connectés entre eux et à la piste P2. De même pour les segments des groupes S(4), S(6), S(8), S(10), S(12) et S(14) qui forment les nombres 20, 40, 50, 70, 80 et 100.

Les cinq segments du groupe S(3) qui forment le chiffre 5 et le segment de prolongation s′(16) sont reliés entre eux et à la piste P3 et il en est de même pour les segments du groupe S(7) qui forment le nombre 15 et le segment s′(46) et pour ceux du groupe S(11) qui forment le nombre 25 et le segment s′ (76).

Les segments des groupes S(5), S(9) et S(13) permettent d'afficher des nombres de repèrage différents pour les deux échelles.

Le groupe S(5) comprend un premier digit avec deux segments verticaux b et c et trois segments horizontaux a, d et g (voir fig. 3a) pour afficher le chiffre 1 ou le chiffre 3 et un second digit de six segments pour afficher le chiffre 0. Les deux segments verticaux du premier digit et les six segments du second sont reliés entre eux et à la piste P1, par l'intermédiaire du segment s(31), tandis que les trois segments horizontaux du premier digit sont reliés à la piste P2.

Le groupe S(9) comprend un premier digit à sept segments a à g, classique (voir fig. 3b), pour afficher les chiffres 2 et 6 et un second digit de six segments pour le chiffre 0.

Les segments a, d, e et g du premier digit et ceux du second digit sont tous reliés entre eux et à la piste P1 tandis que les segments c et f du premier digit sont connectés à la piste P2 et son segment b à la piste P3.

Le groupe S(13) comprend un premier digit de six segments a, b, c, d, f, g, (voir fig. 3c) pour afficher les chiffres 3 et 9 et un second digit de six segments pour le chiffre 0. Là, les segments a, b, c, d et g du premier digit et ceux du second sont reliés ensemble et à la piste P1 alors que le segment f du premier digit est relié à la piste P2.

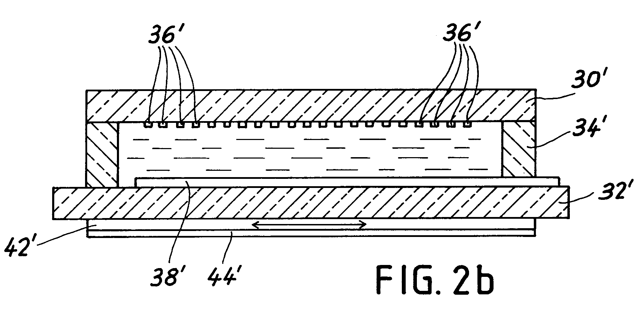

Ainsi, lorsque l'on applique une tension entre la contre-électrode 38 ou 38′ de la cellule (voir figures 2a et 2b) et les pistes P1 et P2 on obtient l'échelle de 0 à 100 qui est représentée sur la figure 4a.

Par contre, si une tension est appliquée entre la contre-électrode et les pistes P1 et P3 la cellule affiche l'échelle de 0 à 30 ou plus précisément de 0 à 33, que l'on peut voir sur la figure 4b.

Avant de décrire un exemple de circuit de commande qui est représenté sur la figure 5 et qui permet d'appliquer ces tensions entre la contre-électrode et les pistes il est utile de préciser deux choses.

La première c'est que la configuration d'électrodes de la figure 3 n'est pas réservée à des cellules comme celles des figures 2a et 2b. Elle pourrait très bien convenir aussi pour d'autres types de cellules, et en particulier celles dont on a parlé mais que l'on n'a pas décrites.

La deuxième chose c'est que si les graduations de l'échelle 0-30 sont constituées par une graduation sur trois de l'échelle 0-100 ce n'est pas seulement parce que cela permet d'avoir une configuration d'électrodes plus simple qui si l'on avait voulu par, exemple faire correspondre le 30 de l'une au 100 de l'autre. Pour le voltmètre de la figure 1 c'est une nécessité car, vu la façon dont on a dit que le circuit de commande 18 du moteur pourrait être réalisé, il faut obligatoirement que le rapport entre les deux échelles soit égal au taux de multiplication du circuit 12.

Le circuit de commande de la cellule, que l'on peut voir sur la figure 5 comprend un oscillateur 46 qui est relié à l'entrée a pour pouvoir être alimenté (voir fig. 1). Lorsque c'est effectivement le cas cet oscillateur produit des impulsions périodiques de fréquence comprise entre 30 et 60 Hz, par exemple de 50 Hz, qui sont directement envoyées à la sortie c du circuit qui est reliée à la contre-électrode 38 ou 38'de la cellule (voir figures 2a et 2b). Ces impulsions sont également appliquées à l'entrée d'un inverseur 48 et à des premières entrées de deux portes OU EXCLUSIF 50 et 52 dont les sorties sont reliées respectivement aux sorties d, e et f du circuit qui sont elles-mêmes reliées aux pistes P1, P2 et P3 de la cellule (voir fig. 3).

L'entrée b du circuit est connectée directement à une seconde entrée de la porte 52 et par l'intermédiaire d'un inverseur 54 à une seconde entrée de la porte 50.

Ainsi, lorsque l'on ferme l'interrupteur 4 pour brancher le voltmètre l'état logique de l'entrée a du circuit passe de "0" à "1" et il apparait alors aux sorties c et d deux signaux en opposition de phase, ce qui permet de créer entre la contre-électrode de la cellule et les segments reliés à la piste P1 une différence de potentiel dont la valeur est égale au double de l'amplitude du signal produit pas l'oscillateur. Donc toutes les graduations et les parties des nombres de repèrage qui sont communes aux deux échelles ainsi que le chiffre 0 sont affichés.

Si, en plus, l'entrée b est à l'état logique "0" le signal que l'on trouve à la sortie f et qui est envoyé à la piste P3 est en phase avec celui de la sortie c. Il s'ensuit que la différence de potentiel entre les segments qui sont reliés à cette piste et la contre-électrode est nulle. Donc tout ce qui complète les graduations et les parties de nombres de repèrage communes pour former l'échelle de 0 à 30 reste invisible.

Par contre, toutes les graduations et les nombres ou parties de nombres de repèrage complémentaires qui permettent de former l'échelle de 0 à 100 apparaissent, puisque le signal issu de la porte 50 et transmis à la piste P2 est alors lui aussi en opposition de phase avec le signal de l'oscillateur.

Naturellement, lorsque l'entrée b est à l'état "1" c'est le contraire qui se produit.

Cela dit, si l'on regarde maintenant à nouveau la figure 1, on constate que la plaque avant de la cellule 26 porte deux butées 56 et 58 pour limiter la course de l'aiguille 24. La position de la première, 56, de ces butées est importante car elle doit obliger l'aiguille à s'arrêter exactement en face de la graduation 0 des deux échelles. Celle de l'autre butée 58 l'est moins. Elle doit seulement permettre à l'aiguille d'atteindre la graduation 100 et il n'y a pas d'inconvénient à ce que cette aiguille puisse aller un peu au-delà.

Comme on l'a déjà expliqué, lorsque l'on branche le voltmètre quand l'interrupteur 14 est ouvert, la cellule 26 affiche instantanément l'échelle de 0 à 100.

Si l'on applique ensuite une tension de par exemple 67 V entre les bornes d'entrée 8 et 10, le circuit de mesure fournit l'information binaire 1000011 au circuit multiplicateur 12 qui se contente de la transmettre telle quelle au circuit de commande 18 et celui-ci se charge alors de transformer cette information en autant d'impulsions motrices qu'il faut pour faire tourner le moteur 20 de 67 pas en marche avant et pour amener l'aiguille 24 en face de la graduation 67 du cadran.

Admettons maintenant que la tension appliquée passe de 67 V à 52 V.

L'information binaire que le circuit de commande 18 reçoit du circuit de mesure, par l'intermédiaire du circuit multiplicateur, devient 0110100 et ce circuit 18 commande alors le moteur 20 de façon qu'il fasse 15 pas en marche arrière pour que l'aiguille vienne se placer en face de la graduation 52 de l'échelle.

Enfin, supposons qu'après que la tension en question ait cessé d'être appliquée entre les bornes 8 et 10 et que l'aiguille ait été ramenée à 0, on ferme l'interrupteur 14. Aussitôt la cellule fait apparaître l'échelle de 0 à 30 à la place de celle de 0 à 100.

Si l'on applique ensuite une autre tension de par exemple 21 V au voltmètre, le circuit 12 multiplie l'information binaire 0010101 qui provient du circuit de mesure par trois.

Par conséquent le circuit de commande 18 reçoit l'information 0111111 et fait faire 63 pas au moteur en marche avant pour que l'aiguille vienne se positionner en face de la graduation 21 de l'échelle.

Si la tension appliquée avait été supérieure à celle qui aurait amené l'aiguille à venir se bloquer contre la butée 58, tout en restant inférieure à 100 V il aurait alors été possible de réouvrir l'interrupteur 14 pour pouvoir lire la valeur de cette tension sur l'échelle de 0 à 100.

A propos de cet interrupteur 14, il faut noter qu'il pourrait très bien, dans une variante, être remplacé par un comparateur qui comparerait l'information de sortie du circuit de mesure au nombre binaire correspondant à 30 et dont le signal de sortie permettrait de sélectionner automatiquement le taux de multiplication du circuit 12 et l'échelle affichée en fonction de la valeur de la tension mesurée.

A noter également que dans une autre variante le signal d'activation pourrait être produit non pas par interrupteur de branchement 4 mais par le circuit de mesure ou d'autres moyens, au moment où une tension serait appliquée entre les bornes 8 et 10 du voltmètre.

D'autre part, il est bien clair que, tout en restant dans le domaine de la mesure de grandeurs électriques, on aurait pu choisir d'autres exemples pour illustrer l'invention.

En particulier, on aurait pu décrire un voltmètre capable d'afficher des tensions sur des échelles de 0 à 1, 10 et 100.

Dans un tel voltmètre, le circuit de multiplication serait supprimé et l'interrupteur de sélection 14 serait remplacé par un commutateur à trois positions qui appliquerait des signaux de sélection au circuit de mesure de façon que celui-ci fournisse la même information binaire pour le même nombre de centièmes de voit, de dizièmes de volt et de volts. Quant à la cellule et à son circuit de commande qui recevrait lui aussi les signaux de sélection, ils seraient conçus pour que l'on ait toujours les mêmes graduations mais avec au-dessus des nombres de repérage différents, par exemple 0, 0.1, 0.2, ..., 1.0 pour l'échelle de 0 à 1 V, 0, 1.0, 2.0, ..., 10.0 pour l'échelle de 0 à 10 V et 0, 10, 20, ..., 100 pour l'échelle de 0 à 100 V.

On aurait également pu décrire un dispositif d'affichage pour indiquer des valeurs de tensions sur une échelle linéaire, graduée par exemple de 0 à 100 V et des valeurs de résistance sur une échelle non linéaire graduée de 0 à 1000 Ω. Un dispositif de ce genre pourrait comporter deux groupes d'entrées par lesquelles il recevrait des informations représentatives des deux grandeurs et un sélecteur commandé par un interrupteur ou automatiquement pour sélectionner les unes ou les autres de ces informations et les appliquer au circuit de commande de moteur qui serait évidemment différent de celui du dispositif d'affichage de la figure 1. De plus, dans ce cas, il n'y aurait plus de correspondance simple entre les deux échelles. Donc, pour éviter les problèmes que risquerait de poser une configuration d'électrodes comparable à celle de la figure 3, on pourrait être amené à utiliser plutôt une cellule à matrice de points.

Ceci dit l'invention n'est évidemment pas limitée à la forme d'exécution qui vient d'être décrite.

Par exemple, on pourrait très bien imaginer un dispositif avec une cellule qui pourrait afficher plusieurs échelles ou, plus généralement, plusieurs systèmes de repérage à des endroits différents et plusieurs organes indicateurs entraînés chacun par un moteur, qui coopéreraient avec ces systèmes de repérage pour indiquer les valeurs de différentes grandeurs. Dans ce cas qui pourrait être notamment celui d'un tableau de bord de véhicule, il suffirait que la cellule puisse afficher sélectivement et sensiblement au même endroit un groupe d'au moins deux systèmes de repérage pour que le dispositif soit conforme à l'invention, mais il pourrait bien entendu y avoir plusieurs groupes de ce genre à différents endroits.

Par ailleurs, il est bien clair que l'on pourrait également faire appel à des moteurs pas à pas linéaires, pour entrainer des organes indicateurs, et à des cellules qui emploiraient des substances électrochromiques ou électroluminescentes comme composant actif.

Enfin, pour terminer, il faut encore signaler qu'un dispositif d'affichage selon l'invention peut très bien recevoir dans certains cas une information représentative de la valeur d'une grandeur à afficher sous forme analogique et se charger lui-même de la mettre sous forme digitale pour pouvoir l'utiliser.

## Revendications

1. Dispositif d'affichage de la valeur d'au moins une grandeur représentée par une information d'entrée, comprenant :
    - un organe indicateur mobile (24) entrainé par un moteur pas à pas (20) ;
    - un premier circuit de commande (18) qui répond au moins indirectement à ladite information d'entrée en appliquant au moteur des impulsions motrices pour amener l'organe indicateur dans une position qui correspond à la valeur de ladite grandeur ; et

- des moyens (26) pour présenter au moins deux systèmes de repérage qui coopèrent avec ledit organe indicateur pour indiquer au moins dans quel domaine se situe la valeur de ladite grandeur, caractérisé par le fait que les moyens pour présenter lesdits systèmes de repérage comprennent une seule cellule d'affichage électro-optique (26) conçue pour afficher ces systèmes de repérage sélectivement et sensiblement au même endroit, en réponse à des signaux de commande, par le fait que ledit dispositif comprend également un deuxième circuit de commande (28) pour appliquer lesdits signaux de commande à ladite cellule en réponse à un signal d'activation et par le fait que le deuxième circuit de commande (28) reçoit également un signal de sélection pour pouvoir appliquer à ladite cellule des signaux de commande différents afin de l'amener à afficher sélectivement l'un ou l'autre desdits systèmes de repérage.

2. Dispositif d'affichage selon la revendication 1, caractérisé par le fait que les deux systèmes de repérage correspondent à des domaines de valeurs différents de ladite grandeur et par le fait qu'il comporte en plus des moyens (12) qui reçoivent également ledit signal de sélection et qui traitent ladite information d'entrée avant de l'envoyer audit premier circuit de commande (18) afin que le nombre d'impulsions motrices appliquées au moteur (20) soit adapté au système de repérage affiché par la cellule (26):

3. Dispositif d'affichage selon la revendication 1, caractérisé par le fait que les deux systèmes de repérage sont prévus pour indiquer les valeurs de grandeurs différentes, ces valeurs étant représentées par des informations d'entrée respectives qui sont reçues par le dispositif d'affichage, et par le fait que ce dispositif comprend en plus des moyens qui reçoivent également ledit signal de sélection et qui sélectionnent l'information d'entrée qui correspond au système de repérage affiché par la cellule (26) pour l'appliquer audit premier circuit de commande (18).

4. Dispositif d'affichage selon l'une quelconque des revendications précédentes, caractérisé par le fait que les systèmes de repérage sont des échelles graduées.

5. Dispositif d'affichage selon l'une quelconque des revendications précédentes, caractérisé par le fait que ledit signal de sélection est produit par des moyens de commutation (14) actionnables manuellement.

6. Dispositif d'affichage selon l'une quelconque des revendications précédentes, caractérisé par le fait que ladite cellule (26) est une cellule à cristal liquide qui fonctionne par réflexion et qui permet d'afficher ledit système de repérage ou lesdits systèmes de repérage en sombre sur fond clair.

7. Dispositif d'affichage selon l'une quelconque des revendications 1 à 5, caractérisé par le fait que ladite cellule (26) est une cellule à cristal liquide qui fonctionne par réflexion et qui permet d'afficher ledit système de repérage ou lesdits systèmes de repérage en clair sur fond sombre.

8. Tableau de bord de véhicule automobile, caractérisé par le fait qu'il comprend au moins un dispositif d'affichage selon l'une quelconque des revendications précédentes.

**Claims**

1. Display device of the value of at least one quantity represented by an input data, comprising :
   - a mobile indicator member (24) driven by a stepping motor (20);
   - a first control circuit (18) which responds at least indirectly to said input data by providing drive pulses to the motor to bring the indicator member to a position corresponding to the value of said quantity; and
   - means (26) for presenting at least two indexing systems which cooperate with said indicator member to indicate at least in which range the value of said quantity is situated, characterized by the fact that the means for presenting said indexing systems comprise only one electro-optical display cell (26) designed to display these indexing systems selectively and substantially at the same place, in response to control signals, by the fact that said device also comprises a second control circuit (28) for supplying said control signals to said cell in response to an activation signal and by the fact that said second control circuit (28) also receives a selection signal whereby it can deliver different control signals to said cell to cause it to selectively display one or the other of said indexing systems.

2. Display device according to claim 1, characterized by the fact that the two indexing systems correspond to ranges of different values of said quantity and by the fact that it further comprises means (12) which also receive said selection signal and which process said input data before sending it to said first control circuit (18) to adapt the number of pulses supplied to the motor (20) to the indexing system displayed by the cell (26).

3. Display device according to claim 1, characterized by the fact that the two indexing systems are designed to display the values of different quantities, these values being represented by respective input data which are received by the display device, and by the fact that this device further comprises means which also receive said selection signal and which select the input data corresponding to the indexing system displayed by the cell (26) for supplying it to said first control circuit (18).

4. Display device according to any one of the preceding claims, characterized by the fact that the indexing systems are graduated scales.

5. Display device according to any one of the preceding claims, characterized by the fact that said selection signal is produced by manually operable switching means (14).

6. Display device according to any one of the preceding claims, characterized by the fact that said cell (26) is a liquid crystal cell which operates by reflection and which displays said indexing system or said indexing systems dark against a light background.

7. Display device according to any one of the preceding claims, characterized by the fact that said cell (26) is a liquid crystal cell which operates by reflection and which displays said indexing system or said indexing systems light against a dark background.

8. Automobile dashboard, characterized by the fact that it comprises at least one display device according to any one of the preceding claims.

**Patentansprüche**

1. Anordnung zum Anzeigen des Wertes mindestens einer durch eine Eingangsinformation repräsentierten Größe, umfassend:
   - ein bewegliches Anzeigeorgan (24), angetrieben von einem Schrittmotor (20);
   - einen ersten Steuerschaltkreis (18), der mindestens indirekt auf die Eingangsinformation anspricht, indem er dem Motor Antriebsimpulse zuführt, um das Anzeigeorgan in eine Position zu bringen, die dem Wert der genannten Größe entspricht; und
   - Mittel (26) zum Präsentieren mindestens zweier Skalensysteme, die mit dem Anzeigeorgan zusammenwirken, um zumindest anzuzeigen, in welchem Bereich sich der Wert der Größe befindet, dadurch gekennzeichnet, daß die Mittel zum Präsentieren der Skalensysteme eine einzige elektro-optische Anzeigezelle (26) umfassen, konzipiert zum selektiven Anzeigen dieser Skalensysteme im wesentlichen an derselben Stelle im Ansprechen auf Steuersignale, daß die Anordnung außerdem einen zweiten Steuerschaltkreis (28) umfaßt zum Anlegen dieser Steuersignale an die Zelle im Ansprechen auf ein Aktivierungssignal, und daß der zweite Steuerschaltkreis (28) ferner ein Auswahlsignal empfängt, um an die Zelle unterschiedliche Steuersignale anlegen zu können, um sie selektiv das eine oder das andere der Skalensysteme anzeigen zu lassen.

2. Anzeigeanordnung nach Anspruch 1, dadurch gekennzeichnet, daß die beiden Skalensysteme unterschiedlichen Wertebereichen der Größe entsprechen, und daß sie ferner Mittel (12) umfaßt, die ebenfalls das Selektionssignal empfangen und die die Eingangsinformation vor der Einspeisung in den ersten Steuerschaltkreis (18) verarbeiten, damit die Anzahl der dem Motor (20) zugeführten Antriebsimpulse an das von der Zelle (26) angezeigte Skalensystem angepaßt wird.

3. Anzeigeanordnung nach Anspruch 1, dadurch gekennzeichnet, daß die beiden Skalensysteme vorgesehen sind für die Anzeige von unterschiedlichen Werten der Größen, welche Werte durch entsprechende Eingangsinformationen repräsentiert werden, die von der Anzeigeanordnung empfangen werden, und daß die Anordnung ferner Mittel umfaßt, welche ebenfalls das Selektionssignal empfangen und die die Eingangsinformation entsprechend dem von der Zelle (26) angezeigten Skalensystem für die Einspeisung in den ersten Steuerschaltkreis (18) selektieren.

4.  Anzeigeanordnung nach einem der vorangehenden Ansprüche, dadurch gekennzeichnet, daß die Skalensysteme mit Einteilungen versehene Skalen sind.

5.  Anzeigeanordnung nach einem der vorangehenden Ansprüche, dadurch gekennzeichnet, daß das Selektionssignal von Umschaltmitteln (14), die manuell betätigbar sind, überzeugt wird.

6.  Anzeigeanordnung nach einem der vorangehenden Ansprüche, dadurch gekennzeichnet, daß die Zelle (26) eine Flüssigkristallzelle ist, die mit Reflektion arbeitet und ermöglicht, das Skalensystem oder die Skalensysteme dunkel vor hellem Hintergrund anzuzeigen.

7.  Anzeigeanordnung nach einem der Ansprüche 1 bis 5, dadurch gekennzeichnet, daß die Zelle (26) eine Flüssigkristallzelle ist, die mit Reflektion arbeitet und die Anzeige des Skalensystems oder der Skalensysteme hell vor dunklem Hintergrund ermöglicht.

8.  Armaturentafel für ein Kraftfahrzeug, dadurch gekennzeichnet, daß sie mindestens eine Anzeigeanordnung nach einem der vorangehenden Ansprüche umfaßt.

FIG. 1

EP 0 330 942 B1

FIG. 2 a

FIG. 5

FIG. 4 a

FIG. 4 b

14

FIG 3a  FIG 3b  FIG 3c

FIG 3

36'　　　　　　　　　　36'

30'

34'

32'

42'

38'　44'

# FIG. 2b